# DEMANDE DE BREVET EUROPEEN

(11) **EP 1 746 072 A2**
(43) Date de publication de la demande: **24.01.2007**
(21) Numéro de dépôt: 06117611.1
(22) Date de dépôt: 20.07.2006
(51) Int. Cl.: B81C 5/00

(54) **Conditionnement d'un composant électronique**

(30) Priorité: 22.07.2005 FR 0552282
(71) Demandeur: COMMISSARIAT A L'ENERGIE ATOMIQUE, 75015 Paris (FR)
(72) Inventeur: Diem, Bernard, 38130, ECHIROLLES (FR)
(74) Mandataire: Poulin, Gérard

(57) **Abrégé**

L'invention concerne un procédé de scellement d'une cavité, munie d'un trou (6), comportant :
- le dépôt sur au moins une partie du capot, d'un matériau conducteur électrique (4, 5),
- le transport d'une partie de ce matériau par électro-migration dans le trou (6) pour former un bouchon (20).

## Description

### DOMAINE TECHNIQUE ET ART ANTÉRIEUR

La présente invention s'applique à la réalisation d'une cavité fermée, et en particulier au conditionnement, dans une cavité protégée, de composants électroniques qui nécessitent un environnement contrôlé pour ce qui concerne la nature du fluide ou la pression environnante.

Elle s'applique notamment aux microsystèmes (MEMS) que les développements en micro-technologies ont permis de réaliser.

Par exemple, de nombreux composants et systèmes intègrent différents types de capteurs ou d'actionneurs. Ces composants sont utilisés pour des fonctions de contrôle ou de mesure. Ces microcomposants, en raison de leur petite taille ou pour des questions de fonctionnement, ont besoin d'être encapsulés dans une atmosphère contrôlée (exempte de poussière, ou sous gaz neutre) ou à des pressions bien contrôlées (sous vide ou non).

Une étape de fermeture est donc effectuée en fin de procédé de réalisation, soit au niveau du composant élémentaire dans un boîtier, soit au niveau du substrat par traitement collectif.

Le traitement collectif est privilégié pour des raison de coût, mais la présent invention s'applique aussi bien à un composant élémentaire.

Différentes techniques sont connues pour assurer cette fermeture.

Selon une première technique, on assemble sous vide un capot (second substrat) par exemple par assemblage de substrats (technique dite aussi « wafer bonding »), ou par frittage de verre, ou par formation d'un eutectique, ou par liaison anodique (technique dite aussi « anodic bonding »). Cette technique est consommatrice de surface pour effectuer le scellement autour de l'élément sensible et nécessite d'utiliser 2 substrats. Il est par ailleurs difficile d'obtenir un bon vide avec une telle technique, décrite par exemple dans les documents U.S. 5,668,033 ou US 5,952,572, puisqu'il se produit, dans l'environnement direct du composant, un dégazage du scellement.

Selon une autre technique, on réalise un dépôt d'une couche pour fermer un trou associé à un conditionnement localisé: ce dépôt peut être réalisé sous vide plus ou moins poussé (évaporation ou pulvérisation), ou sous pression faible par dépôt PECVD ou LPCVD. Ces dépôt sont effectués de façon globale sur tout le substrat (ou à travers un pochoir si la technique le permet) et nécessitent d'autres opérations, par la suite, pour définir la zone utile. L'atmosphère emprisonnée et la pression résiduelle dépendront de la technique utilisée.

On cherche souvent à réaliser un dépôt non conforme pour éviter tout dépôt à l'intérieur de la cavité qui pourrait perturber le microsystème. Cette condition est en général assez incompatible avec la possibilité de fermer le trou. Une telle technique est par exemple décrite dans les documents U.S 5,589,082, et US 6635509.

Encore une autre technique consiste à réaliser une fermeture locale avec un apport extérieur de matière : une bille de matériau fusible est rapportée sur le trou à boucher. Après chauffage et fusion de la bille, le trou est bouché. Cette opération n'est en général pas collective et nécessite de chauffer au-delà de la température de fusion de la bille.

De la même façon que précédemment, il est difficile de contrôler la pression à l'intérieur de la cavité, comme expliqué dans l'article de L. Lin, « MEMS Post Packaging by LocaUzed Heating and Bonding", IEEE TRANSACTIONS ON ADVANCED PACKAGING, Vol. 23, No. 4, pp. 608 Nov. 2000.

Dans tous les cas, il est très difficile de contrôler la pression à l'intérieur de la cavité, du fait du procédé utilisé ou/et de la température du procédé.

Or, pour certains composants de type résonateur, il est important d'avoir un vide poussé - ou une pression contrôlée - à l'intérieur de la cavité, pour avoir un bon coefficient de qualité.

Il se pose donc le problème de trouver un nouveau procédé de réalisation d'un dispositif électronique encapsulé, ne présentant pas tout ou partie des inconvénients présentés ci-dessus.

L'objet de l'invention est justement de pouvoir réaliser la fermeture de l'orifice d'une cavité, par exemple d'un capot d'un dispositif électronique, à des pressions variables, depuis un vide très poussé jusqu'à plusieurs atmosphères, cette fermeture s'effectuant éventuellement à basse température.

### EXPOSÉ DE L'INVENTION

Selon l'invention, on utilise un déplacement de matière par électro-migration pour apporter localement la matière nécessaire pour boucher un trou afin de sceller une cavité munie de ce trou. On peut éventuellement amplifier en outre le phénomène de transport, par exemple par la présence de couches de passivation.

Le déplacement de matière par électro-migration, c'est-à-dire induit par passage d'un courant, est habituellement considéré comme un phénomène parasite qui s'attaque aux connexions métalliques et que l'on cherche donc à minimiser.

C'est donc de manière surprenante que le procédé selon l'invention met en oeuvre ce phénomène.

L'invention concerne notamment un procédé de scellement ou de bouchage d'un capot ou d'un substrat, muni d'un trou ou d'une ouverture, comportant :
- le dépôt sur au moins une partie du capot ou du substrat, d'un matériau conducteur électrique,
- le transport d'une partie de ce matériau par électro-migration dans le trou ou l'ouverture, pour y former un bouchon.

Dans la cavité peut être positionné un composant électronique, par exemple un microsystème de type MEMS, ou encore un résonateur ou un accéléromètre.

Le matériau conducteur électrique peut être par exemple du cuivre, ou de l'aluminium, ou de l'argent, ou de l'indium, ou de l'étain, ou du plomb, ou du magnésium.

Cette matière aura au préalable été déposée et gravée pour obtenir une quantité suffisante de matériau. Par l'application d'un courant électrique (par exemple sur des piste préalablement définies sur le matériau conducteur) la matière sera déplacée en direction du trou à boucher et amenée à ce trou.

Le matériau peut être préalablement déposé par évaporation sous vide ou pulvérisation cathodique.

Le trou a par exemple une dimension maximale ou un diamètre compris entre 0,5 µm et 5 µm, gamme de diamètre ou de dimensions qui permet de mettre en oeuvre le procédé dans les meilleures conditions possibles.

L'épaisseur du matériau conducteur électrique déposé peut être comprise entre 0,1 µm et 5 µm, gamme qui, là encore, est favorable à un procédé optimum.

L'étape d'électro-migration peut avoir lieu à température comprise entre 150°C et 300°C, par exemple 200°C.

Une étape de dépôt d'une couche de protection d'interfaces, sauf autour du trou ou de l'orifice, peut, préalablement à l'électro-migration, être réalisée.

De préférence, l'étape d'électro-migration est réalisée par une circulation de courant, qui est coupée après formation du bouchon du fait du manque de matériau conducteur en dehors de la zone formant le bouchon. Le phénomène est ainsi auto-régulé : tant que le bouchon n'est pas terminé, il y a circulation du courant. Cette circulation est stoppée lorsque le bouchon est formé.

Le scellement ou le bouchage du trou ou de l'ouverture peut être réalisé sous vide, ou sous pression non nulle, par exemple comprise entre 0,5 bar et 1,5 bar. En fait, la pression est ainsi choisie en fonction des besoins dans la cavité délimitée par le capot ou par les parois délimitant l'environnement du composant.

L'opération d'électro-migration peut être effectuée à la pression souhaitée (vide poussé ou non) et à une température relativement basse, par exemple autour de 200°C, pour optimiser le transfert et réduire le temps de l'opération.

Le déplacement de matière mis en oeuvre dans le cadre de l'invention, se faisant par électro-migration, sous l'effet du flux d'électron, sans réaction chimique et sans nécessiter d'environnement particulier pourra donc s'effectuer dans les meilleures conditions de pression, de température ou d'atmosphère selon les besoins.

L'invention concerne également un dispositif électronique comportant une cavité de scellement d'un composant électronique, munie d'un trou, dans laquelle est positionné un composant, et comportant:
- sur au moins une partie de la cavité, une couche de matériau conducteur électrique,
- un bouchon, réalisé dans ce même matériau, fermant ou obstruant un trou.

Le matériau conducteur électrique peut être du cuivre, ou de l'aluminium, ou de l'argent, ou de l'indium, ou de l'étain, ou du plomb, ou du magnésium.

L'épaisseur du matériau conducteur électrique déposé peut être comprise entre 0,1 µm et 5 µm.

Un dispositif selon l'invention peut comporter en outre une couche de protection d'interfaces, sauf autour du trou.

La cavité peut être sous vide, ou sous pression non nulle, par exemple comprise entre 0,5 bar et 1,5 bar.

### EXPOSÉ DÉTAILLÉ DE MODES DE RÉALISATION PARTICULIERS

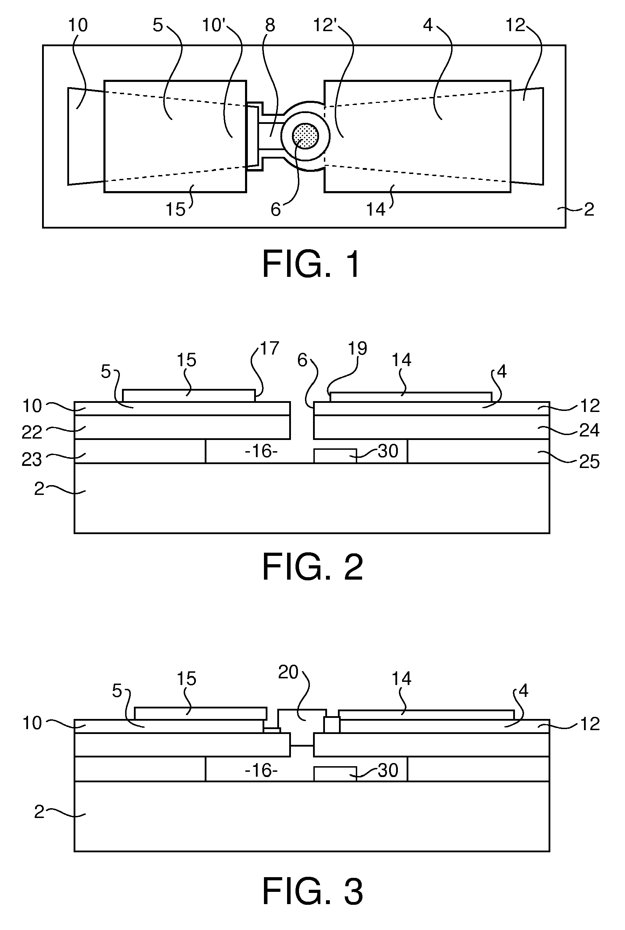

Un exemple de procédé selon l'invention va être décrit en liaison avec les figures 1 - 3.

Un composant, par exemple un microsystème (représenté schématiquement sur la figure 2 par la référence 30) et un capot 22, 24 de protection sont réalisés sur un substrat 2.

Ce capot définit, avec des parois 23, 25, une cavité dans laquelle le composant est isolé.

Dans la suite, on mentionnera un seul composant, mais l'invention s'applique également à plusieurs composants insérés dans la cavité.

L'intérieur 16 de la cavité peut être libéré par l'intermédiaire d'un ou de plusieurs trous tels que le trou 6 (figures 1 et 2). Cette étape de libération comporte par exemple une gravure sélective d'une couche sacrificielle, définie auparavant (par exemple en oxyde SiO2 ou en un polymère tel qu'un polyimide ou BCB). Cette couche sacrificielle peut être celle dans laquelle les parois 23 et 25 sont formées. Dans ce cas, le temps de gravure est contrôlé pour libérer une certaine surface.

Le trou 6 peut avoir un diamètre, ou une dimension maximale mesurée dans un plan parallèle au substrat 2, compris entre 0,5 µm et 5 µm. Par exemple il a 2 µm de diamètre. Plus le diamètre est important, plus il faudra déplacer de matière par électro-migration pour le fermer.

Non loin de l'orifice 6 à boucher une couche 4, 5 de matériau électriquement conducteur, favorable à l'éléctro-migration, est formée. Elle est éventuellement gravée, selon une forme permettant de concentrer la croissance de la matière autour du trou, lors de l'éléctro-migration.

Ce matériau est par exemple en cuivre, ou en l'aluminium, ou en argent, ou en indium, ou en étain, ou en plomb, ou en magnésium.

Des amenées 10, 12 de courant sont prévues et réalisées dans cette couche d'électro-migration, de préférence à ses extrémités. Des pistes de circulation de courant peuvent également être définies sur les couches 4, 5.

Les amenées 10, 12 de courant peuvent, comme illustré sur la figure 2, être formées par un élargissement de la couche 4, 5 de chaque côté, vers l'extérieur du dispositif, la couche se rétrécissant vers l'intérieur, à proximité du trou 6, dans les zones 10', 12' ce qui augmente la densité de courant, et donc le phénomène d'électro-migration, pour concentrer ce phénomène dans la zone souhaitée.

Le phénomène d'électro-migration peut être aussi très sensible aux interfaces. Les surfaces des couches 4 et 5 peuvent donc être protégées par une couche isolante et très adhérente 14, 15 (par exemple : Si02, ou Si₃N₄...) sauf autour de l'orifice 6 pour permettre l'effet et l'accumulation de matière par électro-migration. De préférence, cette couche s'arrête à proximité du trou 6, mais non juste autour du trou. Ceci est illustré en détail sur la figure 2, sur laquelle les références 17, 19 désignent une rupture dans la couche 14, 15, à proximité du trou 6.

La ou les couche 14, 15, en matériau isolant, permettent de protéger l'interface matériau conducteur/air (ou atmosphère environnante) ; elle permettent également, à l'endroit 17, 19 où cette couche s'arrête (là où elle est gravée), de créer un gradient de contrainte qui favorise le phénomène d'accumulation de matière.

On peut dimensionner les amenées de courant proches de l'orifice 6 (par exemple la zone 8) pour que le transfert de matière coupe automatiquement la conduction après la fermeture du trou : la matière ne fermant alors plus le circuit amenant le courant d'une amenée 12 à l'autre amenée 10.

Un courant est injecté avec une densité permettant d'obtenir, autour du trou 6, un effet local d'électro-migration de la matière, avec agglomération sur et/ou dans le trou à boucher. La densité de courant est de préférence au moins égale à 1 MA/cm², par exemple comprise entre 3 MA/cm² et 5 MA/cm², pour que la vitesse du phénomène d'électro-migration soit compatible avec un procédé industriel. Pour favoriser cet effet et réduire le temps de traitement par électro-migration, il est possible de chauffer l'ensemble à des températures d'environ 250°C à 300°C.

Plus l'amplitude ou la densité du courant est élevée, plus la durée du phénomène d'électro-migration pour boucher le trou sera réduite.

Le déplacement de matière est induit par passage d'un courant électrique dans la couche 4, 5. Ce phénomène découle de la modification du processus d'autodiffusion en une diffusion directionnelle, orientée par le transfert d'une partie de la quantité de mouvement des électrons aux ions diffusants. On peut avoir une diffusion en volume, et/ou en surface, et/ou intergranulaire, et/ou aux dislocations et/ou aux interfaces de la matière des couches 4,5.

Selon l'atmosphère présente pendant l'opération d'électro-migration, on retrouve celle-ci à l'intérieur de la cavité après fermeture : si l'opération est réalisée sous vide, il y aura un vide correspondant dans la cavité 16, si l'opération est réalisée sous pression, il y aura la même pression dans cette même cavité.

Par exemple, pour un composant 30 de type résonateur, on cherche à boucher le trou 6 sous le meilleur vide possible.

Selon un autre exemple, pour un composant nécessitant un amortissement visqueux (par exemple un accéléromètre) la fermeture sera effectuée à pression non nulle, atmosphérique par exemple, ou encore comprise entre 0,5 bar et 1,5 bar.

Divers facteurs pourront en outre être optimisés pour favoriser l'électro-migration, notamment la densité de courant, et/ou les interfaces, et/ou la taille des grains, et/ou la température, et/ou les contraintes mécaniques. Par exemple, ces conditions peuvent être déduites à partir de la thèse de P Waltz, décembre 1998: « analyse et modélisation de la tenue à l'électro-migration des interconnexions en régime dynamique », en vue de la présente application qui n'est elle, pas décrite dans ce document.

La présence d'une couche de passivation 4, 5, rend la couche métallique moins sensible à l'électromigration dans les zones où cette couche de passivation est présente. Une couche de passivation permet donc de favoriser l'électro-migration dans les zones où elle n'est pas présente. En outre, un gradient de contrainte est créé dans les zones de rupture telles que les zones 8, 17 et 19, là où la couche de passivation n'est plus présente, gradient qui va favoriser l'électro-migration.

En ce qui concerne la taille des grains des couches métalliques 4, 5, on la choisira de préférence inférieure à 0,5 µm ou comprise entre 0 ,5 µm et 3 µm. L'effet d'électro-migration est favorisé pour des faibles tailles de grains.

Après formation du bouchon 20, on obtient un dispositif électronique comportant une cavité de scellement d'un composant électronique 30, munie d'un trou 6, dans laquelle est positionné le composant 30, et comportant:
- sur au moins une partie de la cavité, une couche 4, 5 de matériau conducteur électrique,
- un bouchon 20, réalisé dans ce même matériau, fermant ou obstruant un trou 6.

Les éventuelles couches de protection 14, 15 restent sur les couches 4, 5.

Le composant 30 est ainsi encapsulé dans les conditions souhaitées. Ce composant peut disposer de ses propres connexions, différentes de la couche 12 (cependant la nature du matériau de cette couche 12 peut être identique à celle du matériau de ces connexions).

## Revendications

1. Procédé de scellement d'une cavité, munie initialement d'au moins un trou (6), comportant :
- le dépôt sur au moins une partie de la cavité, d'un matériau conducteur électrique (4, 5),
- le transport d'une partie de ce matériau par électro-migration dans le trou (6) pour y former un bouchon (20).

2. Procédé selon la revendication 1, un composant électronique (30) étant positionné dans la cavité.

3. Procédé selon la revendication 2, le composant électronique étant un microsystème de type MEMS.

4. Procédé selon la revendication 2 ou 3, le composant électronique étant un résonateur ou un accéléromètre.

5. Procédé selon l'une des revendications 1 à 4, le matériau conducteur électrique étant du cuivre, ou de l'aluminium, ou de l'argent, ou de l'indium, ou de l'étain, ou du plomb, ou du magnésium.

6. Procédé selon l'une des revendications 1 à 5, le matériau conducteur électrique étant déposé par évaporation sous vide ou pulvérisation cathodique.

7. Procédé selon l'une des revendications 1 à 6, le trou ayant un diamètre compris entre 0 ,5 µm et 5 µm.

8. Procédé selon l'une des revendications 1 à 7, l'épaisseur du matériau conducteur électrique déposé étant comprise entre 0,1 µm et 5 µm.

9. Procédé selon l'une des revendications 1 à 8, l'étape d'électro-migration ayant lieu à température comprise entre 150°C et 300°C.

10. Procédé selon l'une des revendications 1 à 9, l'étape d'électro-migration comportant une étape d'injection de courant à une densité au moins égale à 1 MA/cm².

11. Procédé selon l'une des revendications 1 à 10, l'étape d'électro-migration comportant une étape d'injection de courant à une densité comprise entre 3 MA/cm² et 5 MA/cm².

12. Procédé selon l'une des revendications 1 à 11, comportant en outre une étape de dépôt, sur au moins une partie du matériau conducteur, d'une couche (14, 15) de protection d'interfaces, sauf autour du trou (6).

13. Procédé selon l'une des revendications 1 à 12, l'étape d'électro-migration étant réalisée par une circulation de courant, coupée après formation du bouchon (20).

14. Procédé selon l'une des revendications 1 à 13, le scellement étant réalisé sous vide, ou sous pression non nulle, par exemple comprise entre 0,5 bar et 1,5 bar.

15. Procédé selon l'une des revendications 1 à 14, comportant en outre la réalisation de pistes de conduction électrique sur le matériau conducteur avant électro-migration.

16. Dispositif électronique comportant une cavité de scellement d'un composant électronique (30), munie d'un trou (6), dans laquelle est positionné un composant (30), et comportant :
- sur au moins une partie de la cavité, une couche de matériau conducteur électrique (4, 5),
- un bouchon (20), réalisé dans ce même matériau, fermant ou obstruant un trou (6).

17. Dispositif selon la revendication 16, le matériau conducteur électrique étant du cuivre, ou de l'aluminium, ou de l'argent, ou de l'indium, ou de l'étain, ou du plomb, ou du magnésium.

18. Dispositif selon l'une des revendications 16 ou 17, l'épaisseur du matériau conducteur électrique déposé étant comprise entre 0,1 µm et 5 µm.

19. Dispositif selon l'une des revendications 16 à 18, comportant en outre une couche (14, 15) de protection d'interfaces, sur au moins une partie du matériau conducteur, sauf autour du trou (6).

20. Dispositif selon l'une des revendications 10 à 19, le composant électronique étant un microsystème de type MEMS.

21. Dispositif selon l'une des revendications 16 à 20, le composant électronique étant un résonateur ou un accéléromètre.

22. Dispositif selon l'une des revendications 16 à 21, la cavité étant réalisée sous vide, ou sous pression non nulle, par exemple comprise entre 0,5 bar et 1,5 bar.

23. Dispositif selon l'une des revendications 16 à 22, comportant en outre des pistes de conduction électrique sur le matériau conducteur avant électro-migration.
